# EUROPEAN PATENT APPLICATION

(11) **EP 4 447 079 A1**
(43) Date of publication of application: **16.10.2024**
(21) Application number: 24163564.8
(22) Date of filing: 14.03.2024
(51) Int. Cl.: H01G 4/012, H01G 4/33, H10N 97/00, H01L 23/522, H01G 4/005, H01G 4/38

(54) **CAPACITOR COMPONENT AND MANUFACTURING METHOD THEREOF, AND ELECTRONIC DEVICE**

(30) Priority: 12.04.2023 CN 202310427258
(71) Applicant: Huawei Technologies Co., Ltd., Shenzhen, Guangdong 518129 (CN)
(72) Inventor: XU, Jikai, 518129 Shenzhen (CN); LI, Heng, 518129 Shenzhen (CN); GUAN, Yong, 518129 Shenzhen (CN); ZHAO, Nan, 518129 Shenzhen (CN); REN, Yiwei, 518129 Shenzhen (CN)
(74) Representative: Gill Jennings & Every LLP

(57) **Abstract**

This application provides a capacitor component and a manufacturing method thereof, and an electronic device, and relates to the field of capacitor technologies, to reduce a manufacturing process difficulty of a component. The capacitor component includes a first structure layer, a metal routing layer, a first connection pad, and a second connection pad. A trench and metal vias are disposed in the first structure layer, and an opening is provided at a bottom of the trench. The metal routing layer is located at the bottom of the trench and is exposed in the opening. A plurality of electrode layers and a plurality of first dielectric layers are alternately filled in the trench. Each of the first connection pad and the second connection pad is connected to the metal routing layer through the metal via. The plurality of electrode layers include a first electrode layer, a second electrode layer, and at least one intermediate electrode layer. The first electrode layer is in contact with the metal routing layer at the opening. The connection pad directly covers a surface of the second electrode layer. The intermediate electrode layer is connected to the metal routing layer through the metal via. Two adjacent electrode layers are electrically connected to the first connection pad and the second connection pad respectively.

## Description

### TECHNICAL FIELD

This application relates to the field of capacitor technologies, and in particular, to a capacitor component and a manufacturing method thereof, and an electronic device.

### BACKGROUND

Deep trench capacitors (deep trench capacitors, DTCs) with high capacitance density are widely used in chip manufacturing and packaging due to their excellent functions such as energy storage, filtering, and decoupling.

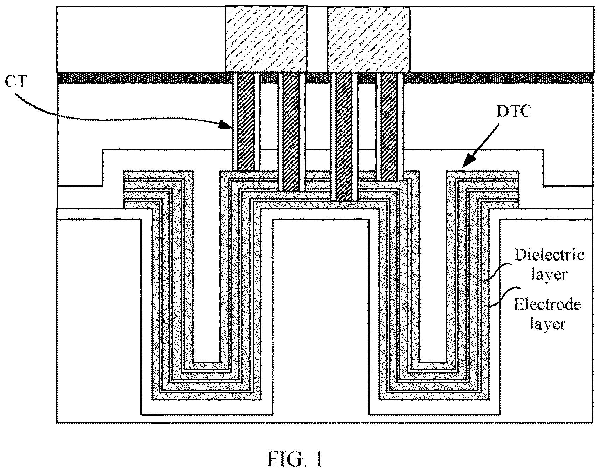

For example, as shown in FIG. 1, in an existing DTC manufacturing process, electrode layers and dielectric layers (namely a dielectric layer) need to be alternately filled in a trench (trench), and a plurality of electrode layers are led out from a top through a contact (contact) hole CT. However, when the contact hole CT is manufactured through an etching (etching) process, etching usually stops on the electrode layer, and an etch selectivity of the electrode layer and the dielectric layer is usually low. Therefore, when the contact hole CT is manufactured, etching is prone to cause damage to an electrode, that is, a process difficulty of etching is high.

Therefore, a DTC with a new structure is urgently needed to reduce a process difficulty of component preparation.

### SUMMARY

This application provides a capacitor component and a manufacturing method thereof, and an electronic device, and provides a DTC of a new structure, to reduce a manufacturing process difficulty of the component.

This application provides a capacitor component. The capacitor component includes a first structure layer, a metal routing layer, a first connection pad, and a second connection pad. A trench and a plurality of metal vias are disposed in the first structure layer, and an opening is provided at a bottom of the trench. The metal routing layer is located at the bottom of the trench and is exposed in the opening. A plurality of electrode layers and a plurality of first dielectric layers are alternately filled in the trench. Each of the first connection pad and the second connection pad is connected to the metal routing layer through the metal via. The plurality of electrode layers include a first electrode layer, a second electrode layer, and at least one intermediate electrode layer located between the first electrode layer and the second electrode layer. The first electrode layer covers an inner side wall of the trench, and is in contact with the metal routing layer at the opening. The first connection pad or the second connection pad covers a surface of the second electrode layer. The intermediate electrode layer extends from the trench, and is connected to the metal routing layer through the metal via. Two adjacent electrode layers are electrically connected to the first connection pad and the second connection pad respectively.

In the capacitor component provided in this embodiment of this application, the metal routing layer is disposed at the bottom of the trench, and the plurality of metal vias are disposed on a side surface of the trench. In this case, an electrode layer (the second electrode layer) at a top layer may be directly connected to a connection pad above, and another electrode layer is led out from a bottom to the connection pad through the metal routing layer and the metal via. For example, an electrode layer (the first electrode layer) at a bottom layer is directly connected to the metal routing layer at the bottom of the trench, and is led upward to the connection pad through the metal via; and the intermediate electrode layer is connected to the metal routing layer through the metal via, and is led upward to the connection pad through the metal via. In other words, in the capacitor component provided in this embodiment of this application, the electrode layer is led out to the connection pad by combining the metal routing layer and the metal via, and no contact hole is required. This can reduce a manufacturing process difficulty and manufacturing costs, and avoid problems such as an electrode layer loss caused by manufacturing the contact hole.

In some possible implementations, the metal routing layer includes a first trace and a second trace. The first trace is located at the bottom of the trench and is exposed in the opening. The first trace and the second trace are respectively connected to the first connection pad and the second connection pad through different metal vias.

In some possible implementations, the first trace and the second trace are located at a same layer.

In some possible implementations, the first structure layer includes an upper structure layer and a lower structure layer, and the upper structure layer is located on a side that is of the lower structure layer and that is away from the first trace. The first trace is located at the bottom of the trench and is exposed in the opening, and the first trace is connected to the first connection pad through a metal via located in the upper structure layer and a metal via located in the lower structure layer. The second trace is located between the upper structure layer and the lower structure layer, and the second trace is connected to the second connection pad through a metal via located in the upper structure layer.

In some possible implementations, the plurality of electrode layers include one intermediate electrode layer. The intermediate electrode layer is connected to the second trace through the metal via. The first connection pad covers the second electrode layer.

In some possible implementations, the plurality of electrode layers include two intermediate electrode layers. The two intermediate electrode layers are a third electrode layer and a fourth electrode layer, and the third electrode layer is closer to the first electrode layer than the fourth electrode layer. The third electrode layer is connected to the second trace through the metal via, and the fourth electrode layer is connected to the first trace through the metal via. The second connection pad covers the second electrode layer.

In some possible implementations, the first dielectric layer includes at least one of HfO₂, ZrO₂, and Al₂O₃, to increase capacitance density of the capacitor component.

In some possible implementations, any two adjacent film layers in the plurality of electrode layers and the plurality of first dielectric layers are a first layer and a second layer respectively, and the first layer is closer to the metal routing layer than the second layer. The first layer and the second layer extend from the trench, and an edge of the second layer exceeds an edge of the first layer. In this way, when each electrode layer and each first dielectric layer are manufactured, an etching process stops on a surface of the first structure layer, thereby reducing an etching process difficulty.

In some possible implementations, the metal via is a copper via, so that a pitch (pitch) between metal vias and a pitch between the metal via and the trench can be reduced, thereby improving the capacitance density of the capacitor component.

In some possible implementations, the first structure layer includes at least one of a dielectric layer and a semiconductor layer.

An embodiment of this application further provides a manufacturing method of a capacitor component. The manufacturing method includes: providing a substrate, where the substrate includes a first surface and a second surface that are disposed opposite to each other; manufacturing, on the first surface of the substrate, a metal routing layer including a first trace and a second trace; manufacturing a trench and a plurality of metal vias along the second surface of the substrate, and exposing the first trace at a bottom of the trench; alternately filling a plurality of electrode layers and a plurality of first dielectric layers in the trench in sequence, where the plurality of electrode layers include a first electrode layer, a second electrode layer, and at least one intermediate electrode layer located between the first electrode layer and the second electrode layer, the first electrode layer covers an inner side wall of the trench, and is in contact with the first trace at an opening, and the intermediate electrode layer extends from the trench, and is connected to the first trace or the second trace through the metal via; and forming a first connection pad and a second connection pad, where the first connection pad or the second connection pad covers a surface of the second electrode layer, the first connection pad and the second connection pad are respectively connected to the first trace and the second trace through the metal vias, and two adjacent electrode layers are electrically connected to the first connection pad and the second connection pad respectively.

An embodiment of this application further provides a manufacturing method of a capacitor component. The manufacturing method includes: manufacturing, on a substrate, a metal routing layer including a first trace and a second trace. A second dielectric layer is manufactured on the metal routing layer, a trench and a plurality of metal vias are manufactured along an upper surface of the second dielectric layer, and the first trace is exposed at a bottom of the trench. A plurality of electrode layers and a plurality of first dielectric layers are alternately filled in the trench in sequence, where the plurality of electrode layers include a first electrode layer, a second electrode layer, and at least one intermediate electrode layer located between the first electrode layer and the second electrode layer; the first electrode layer covers an inner side wall of the trench, and is in contact with the first trace at an opening; and the intermediate electrode layer extends from the trench, and is connected to the first trace or the second trace through the metal via. A first connection pad and a second connection pad are formed, where the first connection pad or the second connection pad covers a surface of the second electrode layer, and the first connection pad and the second connection pad are respectively connected to the first trace and the second trace through metal vias; and two adjacent electrode layers are electrically connected to the first connection pad and the second connection pad respectively.

An embodiment of this application further provides an electronic device. The electronic device includes a circuit board and the capacitor component provided in any one of the foregoing possible implementations. The capacitor component is electrically connected to the circuit board.

### BRIEF DESCRIPTION OF DRAWINGS

FIG. 1 is a schematic diagram of a structure of a capacitor component according to a conventional technology;
FIG. 2 is a schematic diagram of a structure of a capacitor component according to an embodiment of this application;
FIG. 3 is a schematic diagram of a structure of a capacitor component according to an embodiment of this application;
FIG. 4 is a schematic diagram of a structure of a capacitor component according to an embodiment of this application;
FIG. 5 is a schematic diagram of a structure of a capacitor component according to an embodiment of this application;
FIG. 6 is a schematic planar diagram of a trench in a capacitor component according to an embodiment of this application;
FIG. 7 is a schematic diagram of a structure of a connection pad in a capacitor component according to an embodiment of this application;
FIG. 8 is a schematic flowchart of a manufacturing method of a capacitor component according to an embodiment of this application;
FIG. 9 is a schematic diagram of a manufacturing process of a capacitor component according to an embodiment of this application;
FIG. 10 is a schematic diagram of a manufacturing process of a capacitor component according to an embodiment of this application;
FIG. 11 is a schematic diagram of a manufacturing process of a capacitor component according to an embodiment of this application;
FIG. 12 is a schematic diagram of a manufacturing process of a capacitor component according to an embodiment of this application; and
FIG. 13 is a schematic flowchart of a manufacturing method of a capacitor component according to an embodiment of this application.

### DESCRIPTION OF EMBODIMENTS

To make objectives, technical solutions, and advantages of this application clearer, the following clearly and completely describes the technical solutions in this application with reference to the accompanying drawings in this application. It is clear that the described embodiments are merely some rather than all of embodiments of this application. All other embodiments obtained by a person of ordinary skill in the art based on embodiments of this application without creative efforts shall fall within the protection scope of this application.

In the specification, embodiments, claims, and accompanying drawings of this application, the terms "first", "second", and the like are merely intended for distinguishing and description, and shall not be understood as indicating or implying relative importance, or indicating or implying a sequence. The term "and/or" is used for describing an association relationship between associated objects, and represents that three relationships may exist. For example, "A and/or B" may represent the following three cases: Only A exists, only B exists, and both A and B exist, where A and B may be singular or plural. The character "/" generally indicates an "or" relationship between the associated objects. "At least one (term)" means one or more, and "a plurality of" means two or more. "Installation", "connection", "connection", and the like should be understood in a broad sense. For example, the connection may be an electrical connection, or a mechanical connection; the connection may be a fastened connection, a detachable connection, or an integrated connection; and the connection may be a direct connection, or may be an indirect connection through an intermediate medium, or may be a connection inside two elements. In addition, the terms "include", "have", and any variant thereof are intended to cover non-exclusive inclusion. For example, a process, method, system, product, or device that includes a series of steps or units is not necessarily limited to those steps or units expressly listed, but may include other steps or units not expressly listed or inherent to such a process, method, product, or device. "On", "below", "left", "right", and the like are used only relative to the orientation of the components in the accompanying drawings. These directional terms are relative concepts, are used for relative descriptions and clarifications, and may change accordingly as positions at which the components in the accompanying drawings are placed change.

An embodiment of this application provides an electronic device. The electronic device includes a printed circuit board (printed circuit board, PCB, also referred to as a printed circuit board) and a capacitor component electrically connected to the circuit board. The capacitor component uses a deep trench capacitor (DTC) of a new structure, and uses a Damascus process. A plurality of electrode layers are led out from a bottom in a manner of combining a metal routing layer and a metal via, thereby avoiding a problem in the conventional technology that the electrode layer is led out from a top through a contact hole, which results in a high manufacturing process difficulty.

A disposition form of the electronic device is not limited in this application. For example, the electronic device may be an electronic product like a mobile phone, a tablet computer, a notebook computer, an in-vehicle computer, a smartwatch, a smart band, or a server.

A disposition form of the foregoing capacitor component is not limited in this application. The capacitor component may be any component disposed with a deep trench capacitor (DTC), for example, an interposer (interposer) in a 2.5D package structure, an artificial intelligence chip, a high-performance computing chip, or a server logic chip.

The following specifically describes a disposition structure of a new capacitor component provided in an embodiment of this application.

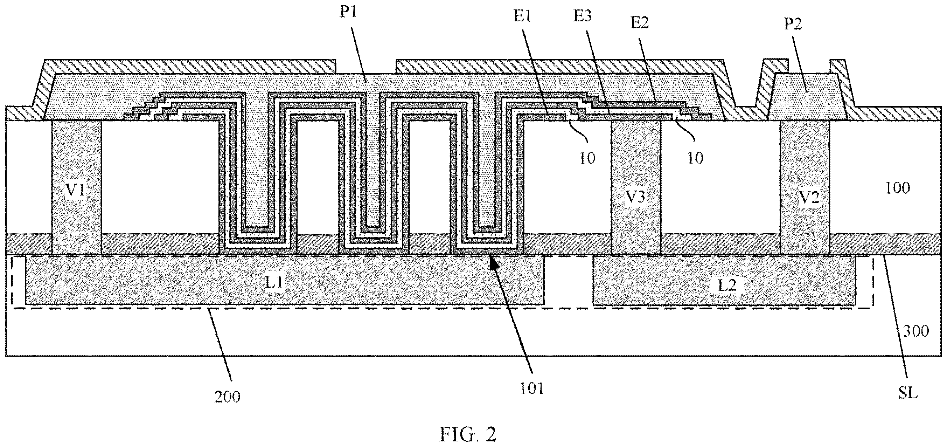

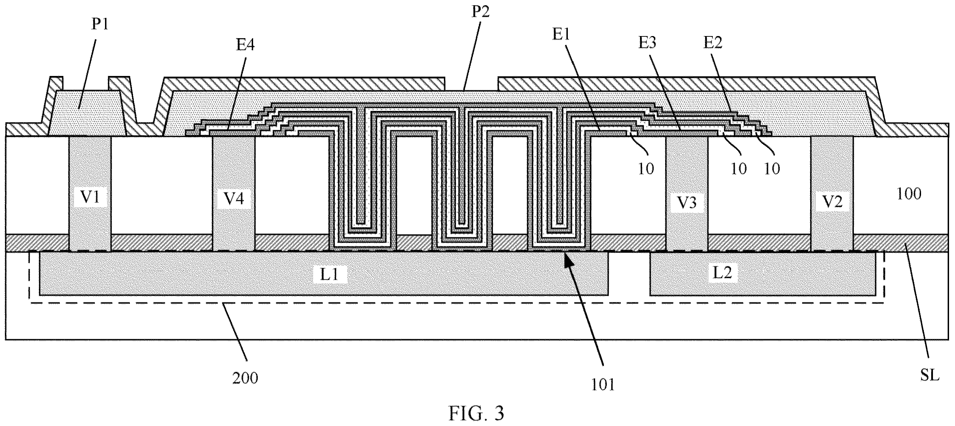

An embodiment of this application provides a capacitor component. As shown in FIG. 2 and FIG. 3, the capacitor component includes a first structure layer 100, a metal routing layer 200 below the first structure layer 100, and connection pads (P1 and P2) above the first structure layer 100.

As shown in FIG. 2 and FIG. 3, the metal routing layer 200 may include a first trace L1 and a second trace L2. According to an actual requirement, each of the first trace L1 and the second trace L2 may be connected to another component below through a metal via. This is not limited in this application.

As shown in FIG. 2 and FIG. 3, at least one trench 101 and a plurality of metal vias (V1, V2, V3, and V4) are disposed in the first structure layer 100. There is an opening at a bottom of the trench 101, and the first trace L1 is exposed at a position of the opening at the bottom of the trench 101. A plurality of electrode layers (E1, E2, E3, and E4) and a plurality of first dielectric layers 10 are alternately filled inside the trench 101. For example, the plurality of electrode layers (E1, E2, E3, and E4) and the plurality of first dielectric layers 10 may extend from the trench 101.

As shown in FIG. 2 and FIG. 3, the connection pads located above the first structure layer 100 may include a first connection pad P1 and a second connection pad P2. The first connection pad P1 is electrically connected to the first trace L1 through a first metal via V1, and the second connection pad P2 is electrically connected to the second trace L2 through a second metal via V2.

It should be noted herein that, according to an actual requirement, the first connection pad P1 may be electrically connected to the first trace L1 through one or more first metal vias V1. FIG. 2 and FIG. 3 show only one first metal via V1. However, this application is not limited thereto. Disposition of the second metal via V2, and disposition of a third metal via and a fourth metal via in the following are similar.

Refer to FIG. 2 and FIG. 3. For the plurality of electrode layers (E1, E2, E3, and E4) and the plurality of first dielectric layers 10 inside the trench 101, the plurality of electrode layers may be at least three electrode layers.

For example, as shown in FIG. 2, in some possible implementations, three electrode layers (E1, E2, and E3) and two first dielectric layers 10 may be disposed in the trench 101. The three electrode layers from bottom to top are sequentially: the first electrode layer E1, the third electrode layer E3, and the second electrode layer E2. One first dielectric layer 10 is disposed between the first electrode layer E1 and the third electrode layer E3, and one first dielectric layer 10 is disposed between the third electrode layer E3 and the second electrode layer E2.

For another example, as shown in FIG. 3, in some possible implementations, four electrode layers (E1, E2, E3, and E4) and three first dielectric layers 10 may be disposed in the trench 101. The four electrode layers from bottom to top are sequentially: the first electrode layer E1, the third electrode layer E3, the fourth electrode layer E4, and the second electrode layer E2. One first dielectric layer 10 is disposed between the first electrode layer E1 and the third electrode layer E3, one first dielectric layer 10 is disposed between the third electrode layer E3 and the fourth electrode layer E4, and one first dielectric layer 10 is disposed between the fourth electrode layer E4 and the second electrode layer E2.

For the plurality of electrode layers inside the trench 101, any two adjacent electrode layers are electrically connected to two different connection pads (P1 and P2). In other words, electrode layers located at an odd-numbered layer are connected to a same connection pad, and electrode layers located at an even-numbered layer are connected to the other connection pad, so that a voltage difference can be formed between any two adjacent electrode layers.

Refer to FIG. 2 and FIG. 3. A specific connection manner of the plurality of electrode layers in the trench 101 may be as follows.

The first electrode layer E1 located at the bottommost covers an inner side wall of the trench 101, and is in contact with the first trace L1 at the opening at the bottom of the trench 101.

The second electrode layer E2 located at the topmost is directly covered by the first connection pad P1 or the second connection pad P2 based on a number of a layer at which the second electrode layer E2 is located. For example, in FIG. 2, the second electrode layer E2 is located at a 3^{rd} layer, and the first connection pad P1 directly covers the second electrode layer E2, to implement an electrical connection between the second electrode layer E2 and the first connection pad P1. For another example, in FIG. 3, the second electrode layer E2 is located at a 4^{th} layer, and the second connection pad P2 directly covers the second electrode layer E2, to implement an electrical connection between the second electrode layer E2 and the second connection pad P2.

An intermediate electrode layer located between the first electrode layer E1 and the second electrode layer E2 may be connected to the first trace L1 or the second trace L2 through a metal via based on a number of a layer at which the intermediate electrode layer is located.

For example, in FIG. 2, one intermediate electrode layer (namely, the third electrode layer E3) is disposed between the first electrode layer E1 and the second electrode layer E2. The third electrode E3 is directly connected to the second trace L2 through the third metal via V3, and is electrically connected to the second connection pad P2 through the second trace L2 and the second metal via V2.

For another example, in FIG. 3, two intermediate electrode layers are disposed between the first electrode layer E1 and the second electrode layer E2, namely, the third electrode layer E3 and the fourth electrode layer E4. The third electrode layer E3 is located between the first electrode layer E1 and the fourth electrode layer E4, and the fourth electrode layer E4 is located between the third electrode layer E3 and the second electrode layer E2. In this case, the third electrode layer E3 is directly connected to the second trace L2 through the third metal via V3, and is electrically connected to the second connection pad P2 through the second trace L2 and the second metal via V2. The fourth electrode layer E4 is directly connected to the first trace L1 through the fourth metal via V4, and is electrically connected to the first connection pad P1 through the first trace L1 and the first metal via V1.

Certainly, five or more electrode layers may be alternatively disposed in the groove 101, and an intermediate electrode layer located between the first electrode layer E1 and the second electrode layer E2 may be disposed with reference to a connection manner of the intermediate electrode layer in FIG. 2 and FIG. 3. Details are not described herein again.

In conclusion, in the capacitor component provided in this embodiment of this application, the metal routing layer 200 is disposed at the bottom of the trench 101, and a plurality of metal vias (V1, V2, V3, and V4) are disposed on a side surface of the trench 101. In this case, the electrode layer (the second electrode layer E2) at a top layer may be directly connected to the connection pad above, and another electrode layer (E1, E3, or E4) is led out from the bottom to the connection pad (P1 or P2) through the metal routing layer 200 and the metal via. For example, the electrode layer (the first electrode layer E1) at a bottom layer is directly connected to the metal routing layer 200 at the bottom of the trench 101, and is led upward to the connection pad through the metal via; and the intermediate electrode layer (E3 or E4) is connected to the metal routing layer 200 through the metal via, and then is led upward to the connection pad through the metal via.

In other words, in the capacitor component provided in this embodiment of this application, the electrode layer is led out to the connection pad (P1 or P2) by combining the metal routing layer 200 and the metal via, and no contact hole is required. This can reduce a manufacturing process difficulty and manufacturing costs, and avoid problems such as an electrode layer loss caused by manufacturing the contact hole.

A specific material of the first dielectric layer 10 disposed between two adjacent electrode layers is not limited in this application, and may be selected according to an actual requirement.

For example, in some possible implementations, to improve capacitance density of the capacitor component, the first dielectric layer 10 may use a high dielectric constant material (namely, an HK material), for example, one or more of HfO₂, ZrO₂, and Al₂O₃.

For example, in some embodiments, the first dielectric layer 10 may use a ZrO₂/Al₂O₃/ZrO₂ multi-film structure (namely, ZAZ).

It should be noted herein that, with reference to FIG. 1, in the conventional technology, when a dielectric layer between adjacent electrode layers uses an HK material, the HK material is contacted when a contact hole CT is manufactured through an etching process, and consequently, device contamination is caused. Therefore, in the conventional technology, to avoid contamination, a dedicated etching device usually needs to be used. As a result, investment in the device is increased, and further, costs of the component are increased.

In comparison, in the capacitor component provided in this embodiment of this application, no contact hole CT needs to be manufactured, thereby avoiding device contamination caused by an HK material when a contact hole CT is manufactured, and no professional device needs to be purchased, thereby reducing costs of the component.

In addition, with reference to FIG. 2 and FIG. 3, in some possible implementations, the plurality of electrode layers (E1, E2, E3, and E4) and the plurality of first dielectric layers 10 in the trench 101 may be disposed to extend from the trench 101, and in any two adjacent film layers, an edge of an upper film layer (which may alternatively be referred to as a second layer) exceeds an edge of a lower film layer (which may alternatively be referred to as a first layer). As shown in FIG. 2, an edge of the first dielectric layer 10 on an upper surface of the first electrode layer E1 exceeds an edge of the first electrode layer E1, and an edge of the second electrode layer E1 exceeds an edge of the first dielectric layer 10 located on a lower surface of the second electrode layer E1. In this way, when each electrode layer (E1, E2, E3, or E4) and each first dielectric layer 10 are manufactured, an etching process stops on a surface of the first structure layer 100, thereby reducing a difficulty of the etching process.

In addition, as shown in FIG. 2 and FIG. 3, in some possible implementations, an etching stop layer SL (stop layer) may be disposed between the first structure layer 100 and the metal routing layer 200. Compared with the first structure layer 100, the etching stop layer SL has a significantly lower etching rate, so that it can be ensured that when the trench 101 and the metal via (V1, V2, V3, or V4) are manufactured in the first structure layer 100, etching can stop in the etching stop layer SL evenly, thereby improving uniformity and consistency of the etching process.

In this embodiment of this application, a disposition form, a material, and the like of the first structure layer 100 may be specifically disposed based on an application scenario of the capacitor component. This is not limited in this application.

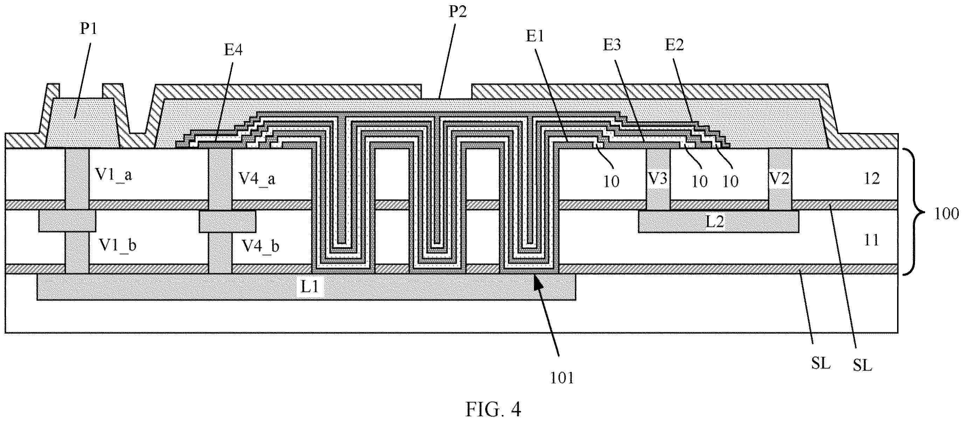

For example, with reference to FIG. 2 and FIG. 3, in some possible implementations, the first structure layer 100 may be a single-layer structure. Refer to FIG. 4. In some possible implementations, the first structure layer 100 may alternatively be a multi-layer structure.

Refer to FIG. 2 and FIG. 3. When the first structure layer 100 is the single-layer structure, in some embodiments, the first structure layer 100 may be a substrate in the capacitor component, for example, a Si substrate. In some other embodiments, the first structure layer 100 may be a dielectric layer, for example, a SiO₂ layer. However, this is not limited thereto.

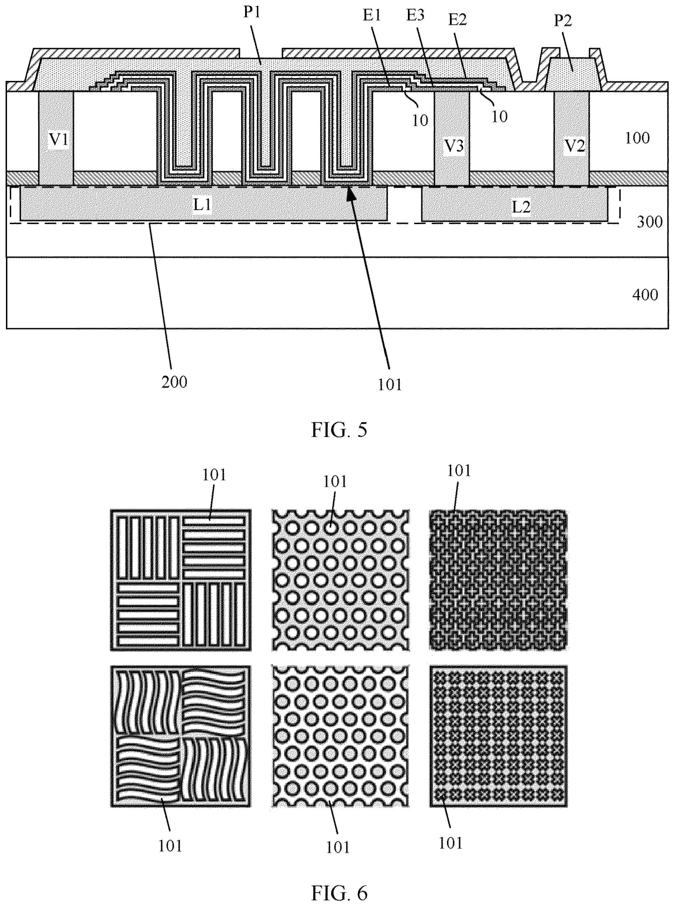

When the first structure layer 100 is the substrate of the capacitor component, the connection pads (P1 and P1) are located on a back side (namely, an active side) of the substrate, and another part may be manufactured on a front side of the substrate according to an actual requirement. When the first structure layer 100 is the dielectric layer, with reference to FIG. 5, a substrate 400 in the capacitor component may be located below the metal routing layer 200.

When the first structure layer 100 is the multi-layer structure, in some embodiments, the first structure layer 100 may include a substrate and a dielectric layer. In some embodiments, the first structure layer 100 may include a plurality of dielectric layers. This is not limited in this application, and may be set according to an actual requirement.

In addition, when the first structure layer 100 is the multi-layer structure, the first trace L1, the second trace L2, and a related metal via may be adjusted according to an actual requirement.

For example, as shown in FIG. 4, in some possible implementations, the first structure layer 100 may include a lower structure layer 11 and an upper structure layer 12. Certainly, in some other possible implementations, an etching stop layer SL may be disposed between the lower structure layer 11 and the upper structure layer 12, to improve uniformity and consistency of an etching process.

When the first structure layer 100 uses the lower structure layer 11 and the upper structure layer 12, as shown in FIG. 4, the first trace L1 and the second trace L2 may be distributed in different metal routing layers, and a metal routing layer in which the first trace L1 is located below the lower structure layer 11, and is exposed in the opening at the bottom of the trench 101. A metal routing layer in which the second trace L2 is located between the lower structure layer 11 and the upper structure layer 12.

Compared with that the first trace L1 and the second trace L2 are located at a same layer in FIG. 2 and FIG. 3, when the second trace L2 is disposed between the lower structure layer 11 and the upper structure layer 12, lengths of the metal vias (V2 and V3) between the second trace L2 and the second connection pad P2 and the electrode layer can be shortened, thereby reducing a manufacturing difficulty. In addition, the metal via connected between the first trace L1 and the first connection pad P1 and the metal via between the first trace L1 and the fourth electrode layer E4 may be disposed in a segment manner, so that a manufacturing difficulty can be reduced. As shown in FIG. 4, the metal via connected between the first trace L1 and the first connection pad P1 may include two metal vias (V1_a and V1_b) manufactured in the upper structure layer 12 and the lower structure layer 11 in segment, and the metal via between the first trace L1 and the fourth electrode layer E4 may include two metal vias (V4_a and V4_b) manufactured in the upper structure layer 12 and the lower structure layer 11 in segment.

In addition, a plurality of trench capacitor units (DTC unit) may be disposed in the capacitor component. In each trench capacitor unit (DTC unit), the trench 101, the connection pads (P1 and P2), and the like may be disposed according to an actual requirement.

For example, a quantity, a shape, a depth, and the like of the trench 101 disposed in a single trench capacitor unit (DTC unit) are not limited in this application, and may be set according to an actual requirement.

For example, a single trench capacitor unit (DTC unit) may include one trench 101, or may include a plurality of trenches 101.

For another example, with reference to FIG. 6, a trench 101 used in a single trench capacitor unit (DTC unit) may be one or a combination of a rectangular trench, a circular trench, a cross trench, a wave trench, and another type of trench.

Certainly, to improve capacitance density of the capacitor component, in practice, a trench structure with a large inner surface area may be selected according to a requirement.

For example, quantities, shapes, sizes, and the like of the first connection pad P1 and the second connection pad P2 in a single trench capacitor unit (DTC unit) are not limited in this application, and may be set according to an actual requirement.

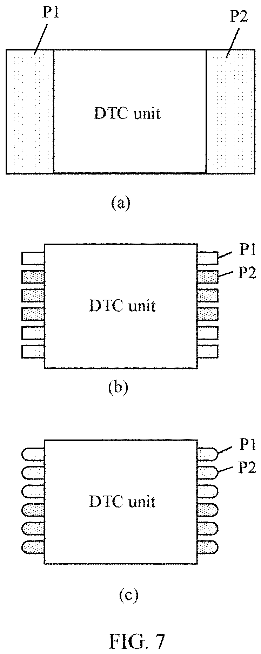

For example, with reference to (a) in FIG. 7, one first connection pad P1 and one second connection pad P2 may be disposed in a single trench capacitor unit (DTC unit). In this case, a plurality of metal vias connected to the first trace L1 are all connected to the first connection pad P1, and a plurality of metal vias connected to the second trace L2 are all connected to the second connection pad P2.

For another example, with reference to (b) and (c) in FIG. 7, a plurality of first connection pads P1 and a plurality of second connection pads P2 may be disposed in a single trench capacitor unit (DTC unit), and different connection pads are connected to different metal vias.

In addition, a disposing form of the metal vias (V1, V2, V3, and V4) located in the first structure layer 100 is not limited in this application.

For example, the metal vias (V1, V2, V3, and V4) in the first structure layer 100 may be aluminum vias or copper vias. This is not limited in this application, and may be set according to an actual requirement.

It should be understood herein that, the aluminum via is filled through physical vapor deposition (physical vapor deposition, PVD), and a depth-width ratio of the aluminum via is generally not greater than 2: 1. In contrast, the copper via may be filled through an electro-chemical plating (electro-chemical plating, ECP) process, so that filling with a high depth-width ratio may be implemented, and a depth-width ratio of the copper via may be more than 5:1. That is, when hole depths are the same, the copper via can be filled with a smaller diameter, thereby obtaining a smaller pitch (pitch).

Therefore, in some possible implementations, all of the metal vias (V1, V2, V3, and V4) disposed in the first structure layer 100 may be copper vias, so that a pitch (pitch) between the metal vias can be reduced, and the capacitance density of the capacitor component can be improved.

The following describes a manufacturing method of the capacitor component provided in an embodiment of this application.

### Manufacturing method 1

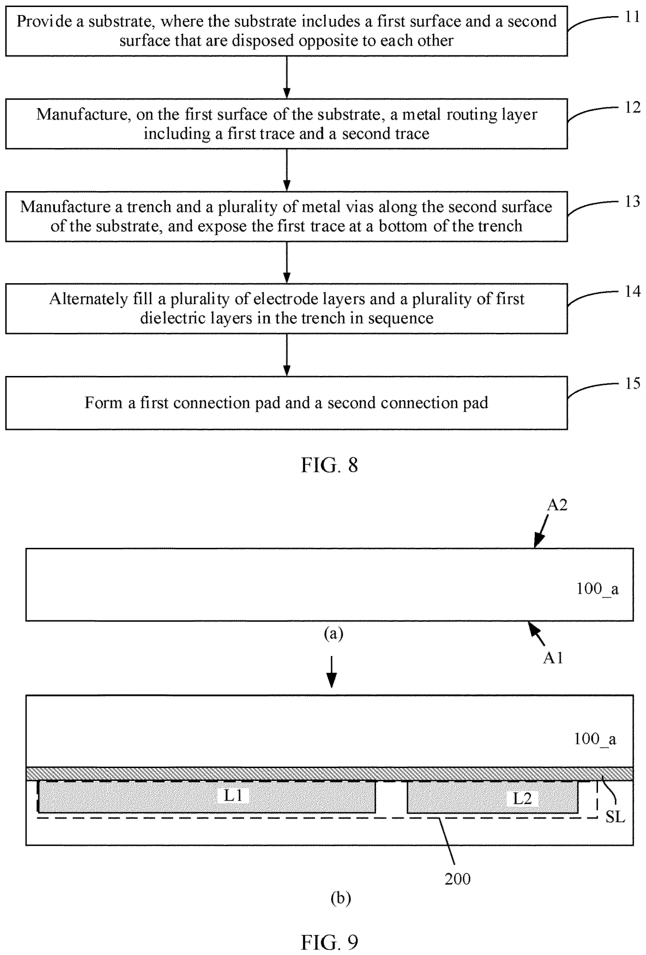

For example, in the manufacturing method 1, a manufacturing method of a capacitor component is provided by using an example in which a substrate is used as a first structure layer 100. As shown in FIG. 8, the manufacturing method may include the following steps.

Step 11: With reference to (a) in FIG. 9, provide a substrate 100_a, where the substrate 100_a includes a first surface A1 and a second surface A2 that are disposed opposite to each other.

For example, the substrate 100_a may be a silicon substrate. According to an actual requirement on the component, another film layer or part may be disposed on the first surface A1 and the second surface A2 of the silicon substrate. This is not limited in this application.

Step 12: With reference to (b) in FIG. 9, manufacture, on the first surface A1 of the substrate 100_a, a metal routing layer 200 including a first trace L1 and a second trace L2.

For example, in some possible implementations, a metal layer may be formed on the first surface A1 of the silicon substrate (100_a) through a metal deposition process in step 12, and the metal layer is etched through an etching process, to form the first trace L1 and the second trace L2, that is, to form the metal routing layer 200.

Certainly, with reference to (b) in FIG. 9, according to an actual requirement, before the metal routing layer 200 is manufactured on the first surface A1 of the substrate 100_a in step 12, an etching stop layer SL may be first manufactured on the first surface A1 of the substrate 100_a. For related descriptions of the etching stop layer SL, refer to the foregoing descriptions. Details are not described herein again.

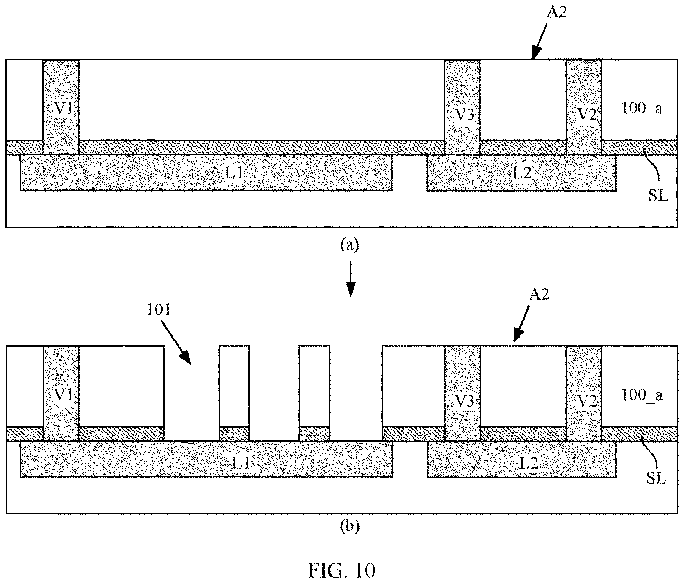

Step 13: With reference to (a) and (b) in FIG. 10, manufacture a plurality of metal vias (V1, V2, and V3) and a trench 101 along the second surface A2 of the substrate 100_a, and expose the first trace L1 at a bottom of the trench 101.

For example, in some possible implementations, with reference to (a) in FIG. 10, first, the plurality of metal vias (V1, V2, and V3) are manufactured along the second surface A2 of the substrate 100_a through atomic layer deposition (atomic layer deposition, ALD) and an etching process, where bottoms of some metal vias (V1) are connected to the first trace L1, and bottoms of some metal vias (V2 and V3) are connected to the second trace L2. Then, with reference to (b) in FIG. 10, a plurality of trenches 101 are manufactured through an etching process along a position that is on the second surface A2 of the substrate 100_a and that corresponds to the first trace L1, and the first trace L1 is exposed at the bottom of the trench 101.

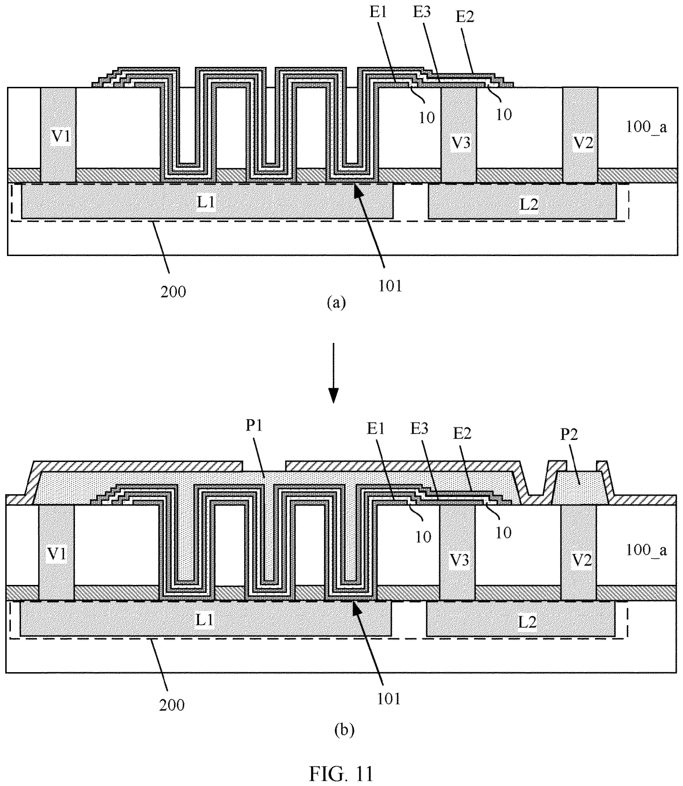

Step 14: With reference to (a) in FIG. 11, alternately fill a plurality of electrode layers (E1, E2, and E2) and a plurality of first dielectric layers 10 in the trench 101.

For example, with reference to FIG. 11, a first electrode layer E1, a first dielectric layer 10, a third electrode layer E3, a first dielectric layer 10, and a second electrode layer E2 may be sequentially manufactured in step 14, that is, three electrode layers and two first dielectric layers 10 are formed. In this case, the first electrode layer E1 covers an inner side wall of the trench 101, and is in contact with the first trace L1 at the opening; and the third electrode layer E3 extends from the trench 101, and may be connected to the first trace L1 through the metal via V3. The second electrode layer E2 is located at a top layer.

In some possible implementations, in step 14, each film layer of the plurality of electrode layers (E1, E2, and E2) and the plurality of first dielectric layers 10 may be separately manufactured through a deposition process and an etching process, and it is ensured that an edge of an upper film layer in two adjacent film layers exceeds an edge of a lower film layer, so that the etching process can stop on a surface of the substrate 100_a, thereby reducing a manufacturing process difficulty. For details, refer to the foregoing related descriptions.

Certainly, before the first electrode layer E1 is deposited in step 14, a SiO₂ layer may be deposited in the groove 101 as a passivation layer.

Step 15: With reference to (b) in FIG. 11, form a first connection pad P1 and a second connection pad P2.

The first connection pad P1 is directly manufactured on a surface of the second electrode layer E2, and is electrically connected to the second electrode layer E2. In addition, the first connection pad P1 is connected to the first trace L1 through the metal via V1, and the second connection pad P2 is connected to the second trace L2 through the metal via V2, so that two adjacent electrode layers are electrically connected to different connection pads.

For example, in step 15, the first connection pad P1 and the second connection pad P2 may be manufactured through an aluminum deposition process and an etching process.

After step 15, other subsequent processes may be performed according to a requirement on the capacitor component. For example, with reference to (b) in FIG. 11, after step 15, a passivation layer may be manufactured, and a window is opened through etching at positions corresponding to the first connection pad P1 and the second connection pad P2 on the passivation layer, to ensure electrical connections between the first connection pad P1 and the second connection pad P2 and another external component.

Certainly, in practice, the foregoing related steps may be correspondingly adjusted according to an actual requirement on the capacitor component.

For example, when a quantity of electrode layers filled in the groove 101 is different, a specific manufacturing process may be adjusted by using step 13 and step 14.

A case in which four electrode layers are filled in the groove 101 is used as an example.

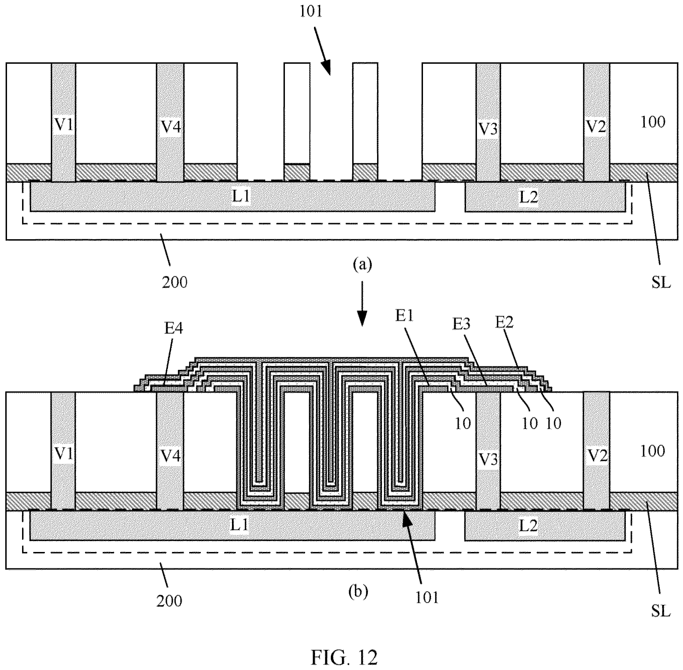

With reference to (a) in FIG. 12, the plurality of metal vias (V1, V2, V3, and V4) may be manufactured along the second surface A2 of the substrate 100_a in step 13, where bottoms of the metal vias (V1 and V4) are connected to the first trace L1, and bottoms of the metal vias (V2 and V3) are connected to the second trace L2.

With reference to (b) in FIG. 12, the first electrode layer E1, the first dielectric layer 10, the third electrode layer E3, the first dielectric layer 10, the third electrode layer E3, the first dielectric layer 10, and the second electrode layer E2 may be sequentially manufactured in the trench 101 in step 14, that is, four electrode layers and three first dielectric layers 10 are formed. In this case, the first electrode layer E1 covers an inner side wall of the trench 101, and is in contact with the first trace L1 at the opening; and the third electrode layer E3 extends from the trench 101, and may be connected to the first trace L1 through the metal via V3. The fourth electrode layer E4 extends from the trench 101, and may be connected to the second trace L2 through the metal via V4. The second electrode layer E2 is located at a top layer.

### Manufacturing method 2

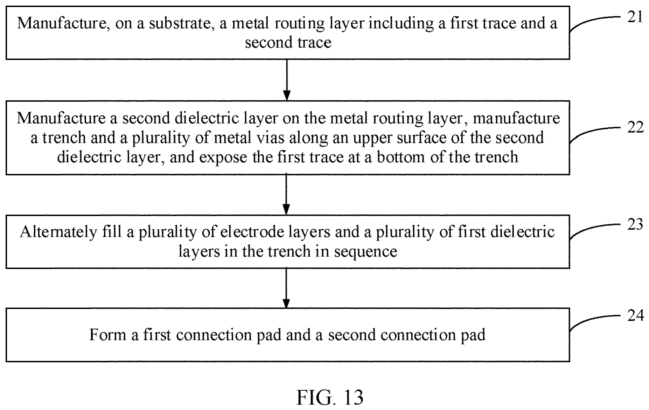

For example, in the manufacturing method 2, a manufacturing method of a capacitor component is provided by using an example in which a dielectric layer (a second dielectric layer) is used as a first structure layer 100. As shown in FIG. 13, the manufacturing method may include the following steps.

Step 21: With reference to FIG. 5, manufacture, on a substrate 400, a metal routing layer 200 including a first trace L1 and a second trace L2.

The substrate 400 may be a silicon substrate. According to an actual requirement on the component, before the metal routing layer 200 is manufactured on a surface of the silicon substrate, another film layer, for example, a dielectric layer 300, may be manufactured.

For step 21, refer to related descriptions of step 12. Details are not described herein again.

Step 22: With reference to FIG. 5, manufacture a second dielectric layer (100) on the metal routing layer 200, manufacture a plurality of metal vias (V1, V2, and V3) and a trench 101 along an upper surface of the second dielectric layer (100), and expose the first trace L1 at a bottom of the trench 101.

For step 22, refer to related descriptions of step 13. Details are not described herein again.

Certainly, according to an actual requirement, before the second dielectric layer (100) is manufactured on the metal routing layer 200 in step 22, an etching stop layer SL may be first manufactured on a surface of the metal routing layer 200. For related descriptions of the etching stop layer SL, refer to the foregoing descriptions. Details are not described herein again.

Step 23: With reference to FIG. 5, alternately fill a plurality of electrode layers (E1, E2, and E2) and a plurality of first dielectric layers 10 in the trench 101.

For step 23, refer to related descriptions of step 14. Details are not described herein again.

Step 24: With reference to FIG. 5, form a first connection pad P1 and a second connection pad P2.

For step 24, refer to related descriptions of step 15. Details are not described herein again.

It should be understood that, in various embodiments of this application, sequence numbers of the foregoing manufacturing processes do not mean execution sequences. The execution sequences of the manufacturing processes should be determined based on specific functions and internal logic of the components, and should not be construed as any limitation on the implementation processes of embodiments of this application.

In addition, for other related content in the foregoing manufacturing method, reference may be correspondingly made to a corresponding part in the foregoing structure embodiment of the capacitor component, and details are not described herein again. For another setting structure of the foregoing capacitor component, adjustment may be made with reference to the foregoing manufacturing method and related manufacturing method, and details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A capacitor component, comprising:
a first structure layer, wherein a trench and a plurality of metal vias are disposed in the first structure layer, and an opening is provided at a bottom of the trench;
a metal routing layer, wherein the metal routing layer is located at the bottom of the trench and is exposed in the opening;
a plurality of electrode layers and a plurality of first dielectric layers that are alternately filled in the trench; and
a first connection pad and a second connection pad, wherein each of the first connection pad and the second connection pad is connected to the metal routing layer through the metal via, wherein
the plurality of electrode layers comprise a first electrode layer, a second electrode layer, and at least one intermediate electrode layer located between the first electrode layer and the second electrode layer; the first electrode layer covers an inner side wall of the trench, and is in contact with the metal routing layer at the opening; the first connection pad or the second connection pad covers a surface of the second electrode layer; and the intermediate electrode layer extends from the trench, and is connected to the metal routing layer through the metal via; and
two adjacent electrode layers are electrically connected to the first connection pad and the second connection pad respectively.

2. The capacitor component according to claim 1, wherein
the metal routing layer comprises a first trace and a second trace;
the first trace is located at the bottom of the trench and is exposed in the opening; and
the first trace and the second trace are respectively connected to the first connection pad and the second connection pad through different metal vias.

3. The capacitor component according to claim 2, wherein
the first trace and the second trace are located at a same layer.

4. The capacitor component according to claim 2, wherein
the first structure layer comprises an upper structure layer and a lower structure layer, and the upper structure layer is located on a side that is of the lower structure layer and that is away from the first trace;
the first trace is located at the bottom of the trench and is exposed in the opening, and the first trace is connected to the first connection pad through a metal via located in the upper structure layer and a metal via located in the lower structure layer; and
the second trace is located between the upper structure layer and the lower structure layer, and the second trace is connected to the second connection pad through a metal via located in the upper structure layer.

5. The capacitor component according to any one of claims 2 to 4, wherein
the plurality of electrode layers comprise one intermediate electrode layer;
the intermediate electrode layer is connected to the second trace through the metal via; and
the first connection pad covers the surface of the second electrode layer.

6. The capacitor component according to any one of claims 2 to 4, wherein
the plurality of electrode layers comprise two intermediate electrode layers, the two intermediate electrode layers are respectively a third electrode layer and a fourth electrode layer, and the third electrode layer is closer to the first electrode layer than the fourth electrode layer;
the third electrode layer is connected to the second trace through the metal via, and the fourth electrode layer is connected to the first trace through the metal via; and
the second connection pad covers the surface of the second electrode layer.

7. The capacitor component according to any one of claims 1 to 6, wherein
the first dielectric layer comprises at least one of HfO₂, ZrO₂, and Al₂O₃.

8. The capacitor component according to any one of claims 1 to 7, wherein
any two adjacent film layers in the plurality of electrode layers and the plurality of first dielectric layers are a first layer and a second layer respectively, and the first layer is closer to the metal routing layer than the second layer; and
the first layer and the second layer extend from the trench, and an edge of the second layer exceeds an edge of the first layer.

9. The capacitor component according to any one of claims 1 to 8, wherein
the metal via is a copper via.

10. The capacitor component according to any one of claims 1 to 9, wherein
the first structure layer comprises at least one of a dielectric layer and a semiconductor layer.

11. A manufacturing method of a capacitor component, comprising:
providing a substrate, wherein the substrate comprises a first surface and a second surface that are disposed opposite to each other;
manufacturing, on the first surface of the substrate, a metal routing layer comprising a first trace and a second trace;
manufacturing a trench and a plurality of metal vias along the second surface of the substrate, and exposing the first trace at a bottom of the trench;
alternately filling a plurality of electrode layers and a plurality of first dielectric layers in the trench in sequence, wherein the plurality of electrode layers comprise a first electrode layer, a second electrode layer, and at least one intermediate electrode layer located between the first electrode layer and the second electrode layer; the first electrode layer covers an inner side wall of the trench, and is in contact with the first trace at an opening; and the intermediate electrode layer extends from the trench, and is connected to the first trace or the second trace through the metal via; and
forming a first connection pad and a second connection pad, wherein the first connection pad or the second connection pad covers a surface of the second electrode layer, the first connection pad and the second connection pad are respectively connected to the first trace and the second trace through the metal vias, and two adjacent electrode layers are electrically connected to the first connection pad and the second connection pad respectively.

12. A manufacturing method of a capacitor component, comprising:
manufacturing, on a substrate, a metal routing layer comprising a first trace and a second trace;
manufacturing a second dielectric layer on the metal routing layer, manufacturing a trench and a plurality of metal vias along an upper surface of the second dielectric layer, and exposing the first trace at a bottom of the trench;
alternately filling a plurality of electrode layers and a plurality of first dielectric layers in the trench in sequence, wherein the plurality of electrode layers comprise a first electrode layer, a second electrode layer, and at least one intermediate electrode layer located between the first electrode layer and the second electrode layer; the first electrode layer covers an inner side wall of the trench, and is in contact with the first trace at an opening; and the intermediate electrode layer extends from the trench, and is connected to the first trace or the second trace through the metal via; and
forming a first connection pad and a second connection pad, wherein the first connection pad or the second connection pad covers a surface of the second electrode layer, the first connection pad and the second connection pad are respectively connected to the first trace and the second trace through the metal vias, and two adjacent electrode layers are electrically connected to the first connection pad and the second connection pad respectively.

13. An electronic device, comprising a circuit board and the capacitor component according to any one of claims 1 to 10, wherein the capacitor component is electrically connected to the circuit board.
